# EUROPÄISCHE PATENTSCHRIFT

(11) **EP 1 263 140 B1**
(45) Veröffentlichungstag und Bekanntmachung des Hinweises auf die Patenterteilung: **07.05.2008**
(21) Anmeldenummer: 02010393.3
(22) Anmeldetag: 08.05.2002
(51) Int. Cl.: H03K 17/0416, H03K 17/687, H01S 5/042

(54) **Schaltungsanordnung zur Erzeugung von kurzen Laserimpulsen mit einer Laserdiode**
Circuit for generating short laser pulses using a laser diode
Circuit pour la génération d'impulsions laser fines utilisant une diode laser

(30) Priorität: 25.05.2001 DE 10125465
(43) Veröffentlichungstag der Anmeldung: 04.12.2002
(73) Patentinhaber: Hella KGaA Hueck & Co., 59552 Lippstadt (DE)
(72) Erfinder: Volk, Hans-Lothar, 59555 Lippstadt (DE)

(56) Entgegenhaltungen:
- US-A- 3 909 745
- US-A- 5 394 415
- US-A- 5 852 358

## Beschreibung

Die Erfindung bezieht sich auf Schaltungsanordnung für mindestens eine Laserdiode zur Erzeugung von kurzen Laserimpulsen mit einer Ansteuerschaltung zur Ansteuerung eines MOS-FETs, welcher die Laserdiode zur Erzeugung des Laserimpulses mit einem auf eine geeignet hohe Spannung aufgeladenen Speicherkondensator verbindet, wobei der Entladestrom des Speicherkondensators zumindest teilweise durch die Laserdiode fließt.

Eine derartige Schaltungsanordnung ist beispielsweise aus der DE 195 46 562 C2 bekannt. Eine Anwendung dieser Schaltungsanordnung ist die Entfernungsmessung mittels Laufzeitmessung von Laserlicht. Um dabei eine hohe Auflösung zu erreichen, d.h. nahe beieinander liegende Ziele noch getrennt auflösen zu können, sind extrem kurze Laserimpulse notwendig, da die Breite des Laserimpulses unmittelbar in die Auflösung eingeht.
Mit der aus der DE 195 46 562 C1 bekannten Schaltungsanordnung sind jedoch nur Laserimpulse mit Impulsbreiten von einigen zehn Nanosekunden möglich. Dabei hat zum Beispiel eine Impulsbreite von 40 Nanosekunden zur Folge, daß Ziele, die weniger 12 Meter voneinander beabstandet sind, nicht mehr getrennt erkannt werden können.

Aufgabe der Erfindung ist es daher, eine Schaltungsanordnung zur Erzeugung sehr kurzer Laserimpulse zu entwickeln.

Diese Aufgabe wird dadurch gelöst, daß die Laserdiode in einem gedämpften LC-Schwingkreis angeordnet ist. Durch diese Maßnahme fließt, wenn der MOS-FET durchgeschaltet hat und der Speicherkondensator entladen wird, durch die Laserdiode nur ein sehr kurzer Stromimpuls, der zumindest nahezu die Form einer sinusförmigen Halbwelle hat. Dabei erzeugt dieser Stromimpuls einen entsprechend kurzen Laserlichtimpuls. Die Dämpfung des LC-Schwingkreises ist so ausgelegt, daß bereits die Amplitude der nächsten positiven Stromhalbwelle so gering ist, daß kein weiterer Laserimpuls mehr erzeugt wird.

Durch diese halbwellengedämpfte sinusförmige Stromimpulsformung wird somit gegenüber der einfachen Entladung des Speicherkondensators ein wesentlich kürzerer Laserimpuls bewirkt, da im Unterschied zum Stand der Technik der durch die Laserdiode fließende Entladestrom nicht exponentiell langsam abnimmt.

Mit der erfindungsgemäßen Schaltungsanordnung können Laserimpulse mit einer Halbwertsbreite von 10 Nanosekunden und weniger erzeugt werden, wodurch die Auflösung einer Entfernungsmesseinrichtung mittels Laserlaufzeitmessung, die mit dieser Schaltungsanordnung betrieben wird, deutlich erhöht wird.

Der LC-Schwingkreises ist vorzugsweise als Parallelschwingkreis ausgebildet, wobei die Laserdiode in Reihe zum Kondensator des Schwingkreises geschaltet ist. Die Kapazität des Schwingkreiskondensators ist dabei wesentlich geringer als die Kapazität des Speicherkondensators.

Vorzugsweise ist parallel zum LC-Schwingkreis eine Diode geschaltet, deren Polung invers zur Polung der Laserdiode ist. Durch die Diode fließt während der negativen Halbwelle ein Teil des Entladestroms, wobei dem Schwingkreis aufgrund des Leistungsabfalls am Innenwiderstand der Diode zur Dämpfung Energie entzogen wird.

Im Unterschied zum Stand der Technik gemäß DE 195 46 562 C2 ist die Laserdiode als zu schaltende Last nicht mit dem Drain des MOS-FETs verbunden, sondern mit dem Source. Wenn die zu schaltende Last mit dem Drain des MOS-FETs verbunden ist, tritt eine unter dem Aspekt kurzer Einschaltzeiten nachteilige dynamische Vergrößerung der Drain-Gate-Kapazität (sogenannter Miller-Effekt) auf, die erfindungsgemäß vermieden wird, indem die zu schaltende Last mit der Source des MOS-FETs verbunden wird. Diese Maßnahme bewirkt eine wesentlich steilere Einschaltflanke des MOS-FETs und damit letztlich einen kürzeren Laserimpuls.

Anhand der beigefügten Zeichnungen soll die Erfindung nachfolgend näher erläutert werden. Es zeigt:
- Figur 1: eine schematische Darstellung der Schaltungsanordnung,
- Figur 2: die Schaltungsanordnung mit den Details der MOS-FET-Ansteuerung,
- Figur 3A: den zeitlichen Verlauf des Trigger-Impulses für die Ansteuerschaltung,
- Figur 3B: den zeitlichen Verlauf des Stromimpulses durch die Laserdiode.

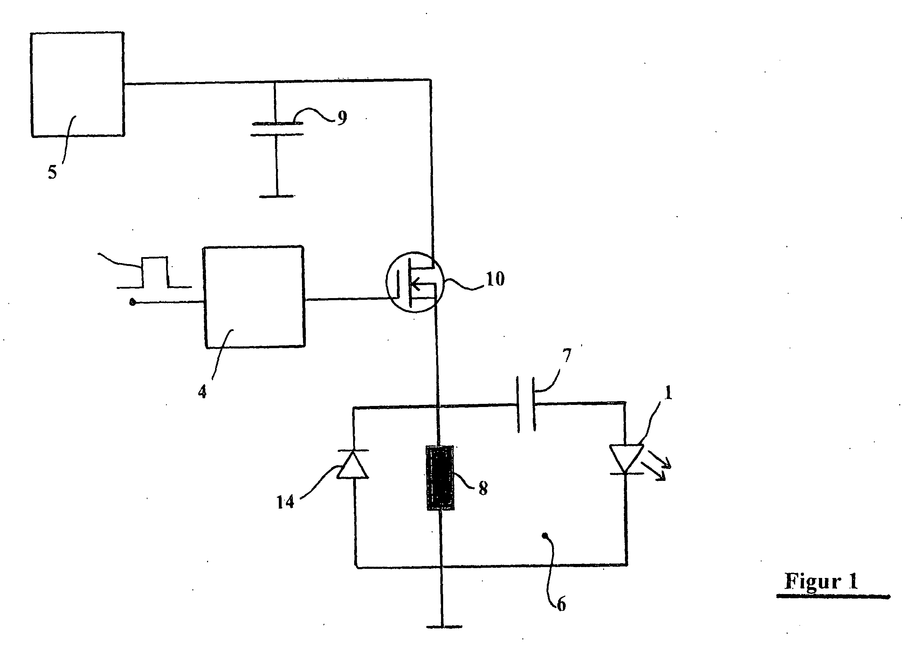

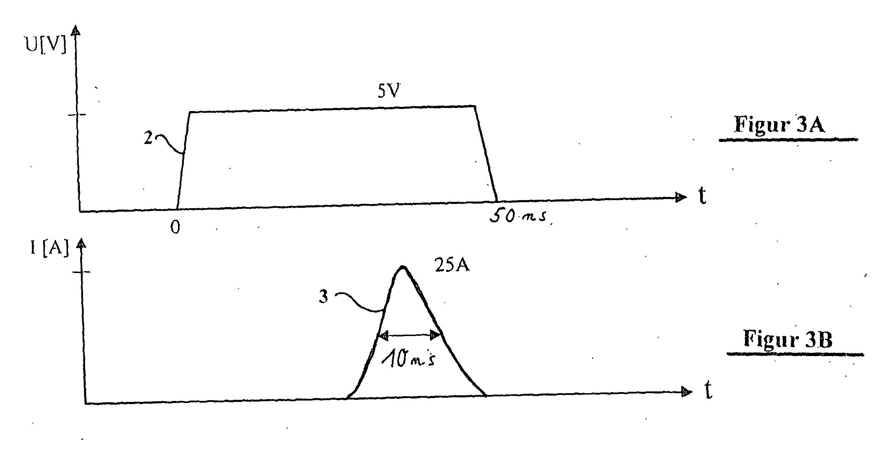

Figur 1 zeigt die erfindungsgemäße Schaltungsanordnung zur Ansteuerung einer Laserdiode (1). Ein Speicherkondensator (9) wird über eine Ladeschaltung (5) auf eine geeignet hohe Spannung (UB) - zum Beispiel 50V bis 100V - aufgeladen. Zur Entladung des Speicherkondensators (9) und damit zum Erzeugen eines Laserimpulses, wird ein MOS-FET-Schalter (10) durchgeschaltet, der dann den Speicherkondensator (9) mit dem LC-Schwingkreis (6) verbindet, in dem die Laserdiode (1) angeordnet ist. Der LC-Schwingkreis (6) - bestehend aus einem Kondensator (7) und einer Spule (8) als induktivem Bauelement- ist vorzugsweise als Parallelschwingkreis ausgebildet, wobei die Laserdiode (1) in Reihe zu dem Kondensator (7) geschaltet ist. Bei dem MOS-FET (10) handelt es sich um einen Kleinleistungstransistor. Das Gate des MOS-FET-Schalters (10) ist mit einer Ansteuerschaltung (4) verbunden, die so ausgelegt ist, daß sie wiederum in vorteilhafter Weise von einer digitalen Logikschaltung (z.B. in CMOS-Technologie; die Logikschaltung selbst ist nicht dargestellt) einen Triggerimpuls (2) empfängt. Die Ansteuerschaltung (4) kann also mit einem TTL-Signal einer Logikschaltung mit geringer Leistung angesteuert werden, während der Ausgang der Ansteuerschaltung (4) in der Lage ist, das Gate des MOS-FETs (10) mit entsprechend hoher Leistung anzusteuern. Die Pulsbreite des TTL-Triggerimpulses (2) beträgt zum Beispiel 50 Nanosekunden. Der Drain des MOS-FETs (10) ist mit dem Speicherkondensator (9) verbunden, während die Source über den LC-Schwingkreis (6) mit der Laserdiode (1) verbunden ist, wobei der LC-Schwingkreis (6) mit der Laserdiode (1) die zu schaltende Last darstellt. Dadurch, daß die Laserdiode (1) mit der Source und nicht mit dem Drain verbunden ist, wird - wie einleitend beschrieben - die Schaltzeit des MOS-FETs (10) deutlich verkürzt. Der gedämpfte LC-Schwingkreis (6), in dem die Laserdiode (1) angeordnet ist, führt dazu, daß durch die Laserdiode (1) bei Entladung des Speicherkondensators (9) nur ein nahezu halbsinusförmiger Stromimpuls - vgl. Figur 3B - fließt. Die Dämpfung wird im wesentlichen durch eine parallel zum LC-Schwingkreis (6) geschaltete Diode (14) bewirkt, die invers zur Laserdiode (1) gepolt ist, wobei während der negativen Halbwelle ein Teil des Entladestroms durch diese Diode (14) fließt und so dem Schwingkreis aufgrund des Leistungsabfalls am Innenwiderstand der Diode (14) Energie entzogen wird. Bereits die Amplitude der nächsten positiven Halbwelle ist so gering, daß kein weiterer Laserimpuls mehr erzeugt wird oder jedenfalls nur noch ein Laserimpuls mit einer vernachlässigbar geringen Leistung. Ohne den erfindungsgemäßen LC-Schwingkreis (6) würde durch die Laserdiode (1) ein exponentiell abnehmender Strom fließen, der einen entsprechend langen Laserimpuls zur Folge hätte.

Um die Beaufschlagung der Laserdiode (1) mit induktiver Spannung in Sperrichtung zu verhindern, was ansonsten zu Beschädigungen führen könnte, ist im dem LC-Schwingkreis (6) parallel zur Laserdiode (1) eine entgegengesetzt gepolte Diode (15) geschaltet.

Beide Dioden (14, 15) - Schutzdiode (15) wie auch Dämpfungsdiode (14) - sind vorzugsweise Schottky-Dioden, damit auf Umladungen entsprechend schnell reagiert werden kann.

Die Kombination der vorstehend beschriebenen Maßnahmen - Anordnung der Laserdiode (1) in einem LC-Schwingkreis (6) und Verbindung der Laserdiode (1) mit der Source des MOS-FETs (10) - bewirkt besonders kurze Laserimpulse.

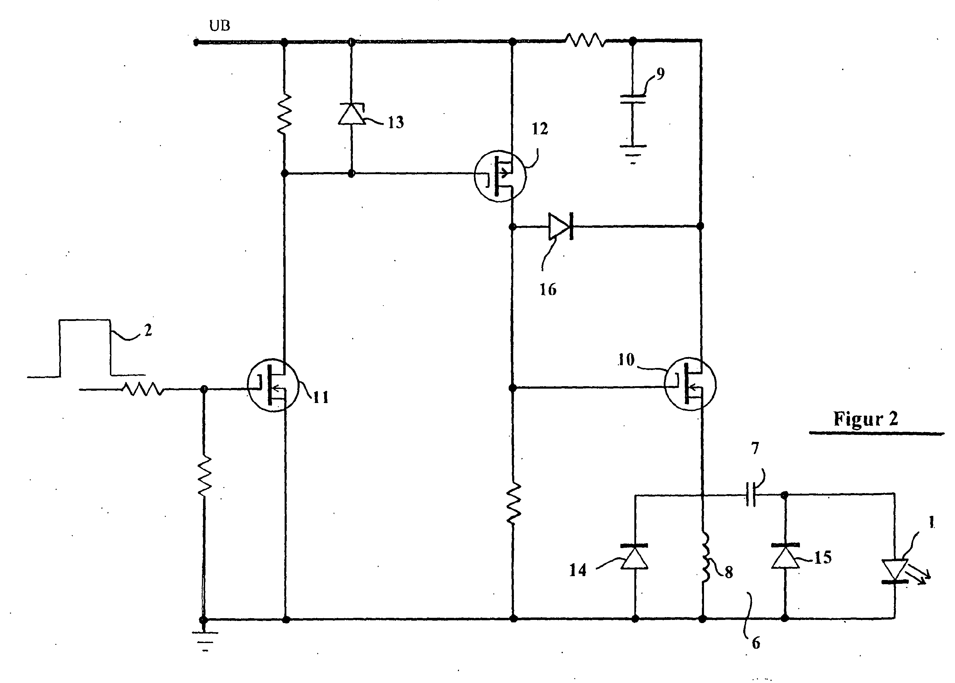

In Figur 2 zeigt die Schaltungsanordnung mit Details der Ansteuerschaltung (4).
Der Speicherkondensator (9) ist jeweils vor einem Laserimpuls auf die Betriebsspannung (UB) aufgeladen. Die Ansteuerung des MOS-FETs (10), der den Speicherkondensator (9) über den LC-Schwingkreis (6) an die Laserdiode (1) durchschaltet, erfolgt über das sequentielle Einschalten zweier vorgeschalteter MOS-FETs (11, 12). Durch die positive Flanke des TTL-Triggersignals (2) am Gate des Eingangs-MOS-FETs (11) wird dieser durchgeschaltet. Bei diesem MOS-FET (11) handelt es sich um einen selbstsperrenden N-Kanal- MOS-FET. Das Gate ist über einen Widerstand mit Masse verbunden. Die Source ist direkt mit Masse verbunden. Der Drain dieses MOS-FETs (11) ist über einen Widerstand mit der Betriebsspannung (UB) und gleichzeitig mit dem Gate eines selbstsperrenden P-Kanal-MOS-FETs (12) verbunden. Die Source des P-Kanal- MOS-FETs (12) ist der Betriebsspannung (UB) verbunden. Der Drain des P-Kanal- MOS-FETs (12) ist mit dem Gate des N-Kanal- MOS-FET (10) verbunden, der letztendlich den Speicherkondensator (9) mit dem LC-Schwingkreis (6) und der Laserdiode (1) verbindet.

Mit dem Durchschalten des Eingangs-MOS-FETs (11) wird das Gate des nachgeschalteten P-Kanal-MOS-FETs (12) nach Masse gezogen, wodurch der P-Kanal-MOS-FET (12) durchschaltet. Dadurch wird nun wiederum der N-Kanal- MOS-FET (10) durchgeschaltet, der letztendlich den Speicherkondensator (9) mit dem LC-Schwingkreis (6) und der Laserdiode (1) verbindet.

Um das Gate des N-Kanal- MOS-FETs (10) vor Überspannungen zu schützen, ist zwischen Gate und Drain eine Diode (16), vorzugsweise eine schnelle Schottky-Diode, geschaltet. Um das Gate des P-Kanal- MOS-FETs (12) vor Überspannungen zu schützen, ist zwischen Gate und Source eine Zenerdiode (13) geschaltet, die beim Durchschalten des Eingangs-MOS-FETs (11) den Spannungsabfall am Gate des P-Kanal-MOS-FETs (12) gegenüber der Betriebsspannung auf maximal die Zenerspannung begrenzt.

Für den Eingangs-MOS-FET (11) wird ein MOS-FET verwendet, der für kleine Leistungen und Ströme dimensioniert ist und daher in vorteilhafter Weise mit einem TTL-Signal geschaltet werden kann. Demgegenüber ist der nachgeschaltete P-Kanal-MOS-FET (12) für größere Leistungen und Ströme dimensioniert, da dieser MOS-FET (12) kurzzeitig entsprechend hohe Schaltströme für den nachgeschalteten N-Kanal-MOS-FET (10) liefern muß.

Die Betriebsspannung auf die der Speicherkondensator (9) aufgeladen wird, kann je nach Anwendung und Mess-Situation geändert werden und ist somit variabel.

In einer nicht dargestellten Ausführungsform ist die vorstehend beschriebene Ansteuerschaltung über einen Multiplexer mit mehreren Laserdioden verbindbar. Damit wird die Ansteuerung von mehreren Laserdioden mit nur einer Ansteuerschaltung realisiert. Die mehreren Laserdioden sind dann vorzugsweise mit ihren Kathoden gemeinsam mit Masse verbunden.

### Bezugszeichenliste:

- 1): Laserdiode
- 2): Triggerimpuls
- UB): Betriebsspannung
- 3): Stromimpuls durch die Laserdiode
- 4): Ansteuerschaltung
- 5): Ladeschaltung
- 6): LC-Schwingkreis
- 7): Kondensator des Schwingkreises
- 8): Spule des Schwingkreises
- 9): Speicherkondensator
- 10): MOS-FET zum Durchschalten des Speicherkondensators an die Laserdiode
- 11): Eingangs-MOS-FET
- 12): P-Kanal-MOS-FET
- 13): Zenerdiode
- 14): Dämpfungsdiode für den Schwingkreis
- 15): Schutzdiode für die Laserdiode
- 16): Schutzdiode für das Gate des MOS-FETs ()

## Patentansprüche

1. Schaltungsanordnung für mindestens eine Laserdiode (1) zur Erzeugung von kurzen Laserimpulsen mit einer Ansteuerschaltung (4) zur Ansteuerung eines MOS-FETs (10), welcher die Laserdiode (1) zur Erzeugung des Laserimpulses mit einem auf eine geeignet hohe Spannung aufgeladenen Speicherkondensator (9) verbindet, wobei der Entladestrom des Speicherkondensators (9) zumindest teilweise durch die Laserdiode (1) fließt,
**dadurch gekennzeichnet, daß**
die Laserdiode (1) in einem gedämpften LC-Schwingkreis (6) angeordnet ist.

2. Schaltungsanordnung nach Anspruch 1,
**dadurch gekennzeichnet, daß**
die Laserdiode (1) in einem LC-Parallelschwingkreis (6) angeordnet ist, wobei die Laserdiode (1) in Reihe zum Kondensator (7) des Schwingkreises (6) geschaltet ist.

3. Schaltungsanordnung nach einem der vorstehenden Ansprüche,
**dadurch gekennzeichnet, daß**
parallel zum LC-Schwingkreis (6) eine Diode (14) geschaltet ist, wobei die Polung dieser Diode (14) umgekehrt zur Laserdiode (1) ist.

4. Schaltungsanordnung nach Anspruch 3,
**dadurch gekennzeichnet, daß**
die Diode (14) eine Schottky-Diode ist.

5. Schaltungsanordnung nach Anspruch 1,
**dadurch gekennzeichnet, daß**
- der LC-Schwingkreis mit der Laserdiode (1) eine zu schaltende Last darstellt, wobei diese zu schaltende Last mit der Source des MOS-FETs (10) verbunden ist,
- der Speicherkondensator (9) mit dem Drain des MOS-FETs (10) verbunden ist.

## Claims

1. Circuitry for at least one laser diode (1) for generating short laser pulses including a drive circuit (4) for driving a MOS-FET (10) which, to allow the laser diode (1) to generate the laser pulse, connects the laser diode (1) with a storage capacitor (9) that has been charged to a suitably high voltage level, where at least some of the discharge current of the storage capacitor (9) flows through the laser diode (1),
**characterized in that**
the laser diode (1) resides in a damped resonant LC circuit (6).

2. Circuitry of claim 1,
**characterized in that**
the laser diode (1) resides in a parallel resonant LC circuit (6), where the laser diode (1) is connected in series with the capacitor (7) of the resonant circuit (6).

3. Circuitry of one of the above claims,
**characterized in that**
a diode (14) is connected in parallel with the resonant LC circuit (6), where the polarity of this Diode (14) reverses that of the laser diode (1).

4. Circuitry of claim 3.
**characterized in that**
the diode (14) is a Schottky diode.

5. Circuitry of claim 1,
**characterized in that**
- the resonant LC circuit and the laser diode (1) make up a load to be controlled, where the load to be controlled is connected with the source of the MOS-FET (10),
- the storage capacitor (9) is connected with the drain of the MOS-FET (10).

## Revendications

1. Montage électrique pour au moins une diode laser (1) permettant la génération d'impulsions laser courtes avec un circuit de commande (4) permettant la commande d'un MOSFET ou transistor à effet de champ de semi-conducteur d'oxyde de métal (10), lequel relie la diode laser (1) permettant la génération de l'impulsion laser à un condensateur de puissance (9) chargé à une tension suffisamment élevée, le courant de décharge du condensateur de puissance (9) s'écoulant au moins partiellement par la diode laser (1),
**caractérisé en ce que**
la diode laser (1) est disposée dans un circuit oscillant LC amorti.

2. Montage électrique selon la revendication 1,
**caractérisé en ce que**
la diode laser (1) est disposé dans un circuit oscillant parallèle LC (6), la diode laser (1) étant montée en série par rapport au condensateur (7) du circuit oscillant (6).

3. Montage électrique selon l'une des revendications précédentes,
**caractérisé en ce que**
une diode (14) est montée en parallèle au circuit oscillant LC (6), la polarité de cette diode (14) étant inversée par rapport à la diode laser (1).

4. Montage électrique selon la revendication 3,
**caractérisé en ce que**
la diode (14) est une diode Schottky.

5. Montage électrique selon la revendication 1,
**caractérisé en ce que**
- le circuit oscillant LC représente une charge à commuter avec la diode laser (1), cette charge à commuter étant reliée à la source du MOSFET (10),
- le condensateur de puissance (9) est relié au drain du MOSFET (10).
